Europäisches Patentamt

(19) European Patent Office

Office européen des brevets

(11) Publication number: **0 058 557**
**B1**

(12) **EUROPEAN PATENT SPECIFICATION**

(45) Date of publication of patent specification: **07.05.86**

(21) Application number: **82300764.6**

(22) Date of filing: **16.02.82**

(51) Int. Cl.⁴: **H 01 L 27/02, H 02 H 9/04**

(54) Protection element for a semiconductor device.

(30) Priority: **17.02.81 JP 22008/81**
**31.08.81 JP 136663/81**

(43) Date of publication of application:
**25.08.82 Bulletin 82/34**

(45) Publication of the grant of the patent:
**07.05.86 Bulletin 86/19**

(84) Designated Contracting States:
**DE FR GB NL**

(56) References cited:
**US-A-3 667 009**

**Patent Abstracts of Japan Vol. 5, No. 149, 19 September 1981**

(73) Proprietor: **FUJITSU LIMITED**
**1015, Kamikodanaka Nakahara-ku**
**Kawasaki-shi Kanagawa 211 (JP)**

(72) Inventor: **Shirato, Takehide**
**6-26 Sengen-cho**
**Hiratsuka-shi Kanagawa, 254 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to an element responsible for the protection of an associated ordinary element of a semiconductor device from the application thereto of a voltage higher than a maximum voltage which is allowed to be applied to the ordinary element.

The magnitude of voltage allowed to be applied to integrated circuits is rather limited, because the geometrical dimensions of integrated circuits are fairly small. It is therefore preferable that each ordinary element included in an integrated circuit be associated with a specific element which is responsible for discharging any unexpectedly or unacceptably high voltage to ground, whenever such an unacceptably high voltage would otherwise be applied to the ordinary element, for the ultimate purpose of protecting the ordinary element from destruction by such a high voltage. In reality, each integrated circuit contains a group of protection elements having the aforementioned purpose. Since ordinary elements of an integrated circuit are designed to work with a relatively low voltage, for example 5V, the working voltage of such protection elements is ordinarily selected to be in the range 6V to 7V. However, a specific case in which discrete elements such as fluorescent type display elements, operative in a voltage range of for example 40V to 50V, are connected with ordinary elements included in an integrated circuit, requires a protection element the working voltage of which is in excess of the aforementioned voltage range 40V to 50V. That is to say, a protection element the ordinary working voltage range of which is higher than that of protection elements available in the prior art (6V to 7V) is required.

The simplest structured protection element is a p-n junction operated with a reverse bias, which breaks down when a voltage higher than an allowable voltage is applied to the associated or protected ordinary element.

An improved structure for a protection element is a type of parasitic MOS field effect transistor of which the gate and drain are connected with a protected element and of which the source is grounded. The parasitic MOS field effect transistor is designed to become conductive only when the drain has applied thereto a voltage the same as or higher than the working voltage of the protection element. Therefore, the threshold voltage is required to be selected to be relatively high or slightly more than the working voltage. Therefore, the impurity concentration of a channel stopper region is required to be relatively high. However, such high impurity concentration incurs a disadvantage in that a lesser breakdown voltage between the drain region and channel stopper region is provided, giving rise to difficulty in the production of a protection element of the parasitic MOS field effect transistor type having a high working voltage.

Another improved structure for a protection element is a lateral bipolar transistor structure in which the emitter is connected with a protected element and in which the base and collector are grounded. The lateral bipolar transistor is designed to become conductive only when the emitter has applied thereto a voltage equal to or higher than the working voltage of the protection element. In other words, a p-n junction between the emitter region and a substrate, or between the emitter region and the base region which actually is a channel stopper region, is broken down when a voltage the same as or higher than the working voltage of the protection element is applied to the emitter. When this happens the substrate is charged up as a result. As soon as the potential of the substrate exceeds the potential of the collector, the lateral bipolar transistor becomes conductive, as a result functioning as a protection element. Accordingly, the working voltage of the lateral bipolar transistor type protection element is actually determined by the breakdown voltage between the emitter region and the substrate, or by the breakdown voltage between the emitter region and the base region which actually is a channel stopper region. However, since the essential function of the channel stopper region is to prevent a parasitic transistor function from occurring for the entire area of an integrated circuit, the range of impurity concentrations which can be used to provide a channel stopper region is rather restricted, as a result making it difficult to produce a protection element of a lateral bipolar transistor type having a high working voltage. In reality, even if a dose is selected to be as low as $10^{13}/cm^2$, it is difficult to make the working voltage of such a protection element higher than 30V.

Accordingly, previously available protection element structures are not satisfactory for production of a protection element having a high working voltage, for example 40V or more.

According to the present invention there is provided a protection element, for protecting an ordinary element of a semiconductor device from the application thereto of a voltage higher than a maximum permissible voltage, the protection element comprising:

a first region, of a first conductivity type, having an insulating layer covering a major part thereof;

a second region, of a second conductivity type, opposite to the first conductivity type, provided in a first selected upper portion of the first region;

a third region, of the second conductivity type, provided in a second selected upper portion of the first region;

a fourth region, of the first conductivity type, of higher impurity concentration than the first region, covered by the insulating layer, between the second and third regions, contacting the third region (4, 95) but separated from the second region; and

first and second electrodes connected respectively to the second region and the third region.

An embodiment of the present invention provides a protection element, responsible for protection of an ordinary element included in a semiconductor device from the application thereto of a voltage higher than a maximum voltage which is allowed to be applied to the ordinary element, the working voltage of which protection element is increased; that is, the voltage at which the protection element is expected to operate is increased.

A protection element embodying the present invention is a type of lateral bipolar transistor.

In an embodiment of the present invention the separation of the second region of the lateral bipolar transistor, from the fourth region results in an increase in the breakdown voltage between the emitter and the base of the lateral bipolar transistor up to a value determined by the specific resistance of the first region, because the depletion layer fairly extends to a considerable extent when the potential of the second region (the emitter) is increased, as a result further increasing the working voltage of a protection element embodying the present invention to satisfactory level, for example up to 40 or 50V or higher.

Experimental results have demonstrated that the working voltage of a protection element in accordance with the present invention, that is, the voltage at which an ordinary element is safely protected by a protection element in accordance with the present invention, can be successfully increased to 50V or higher, in the case in which the distance between the second region and the fourth region is 3 micrometers.

Reference is made, by way of example, to the accompanying drawings, in which:—

Figure 1 is a schematic diagram illustrating the connection of a protection element embodying the present invention to an associated or protected ordinary element which is connected to a fluorescent tube type display element which is operative at a voltage of approximately 40V and which is a discrete circuitry element,

Figure 2 is a cross-sectional view of a portion of a wafer containing a protection element embodying the present invention,

Figure 3 is a plan view of the portion of the wafer containing a protection element as illustrated in Figure 2;

Figure 4 is a cross-sectional view of a wafer in the course of production of a protection element embodying the present invention, after completion of a step for production of a mask employed for implantation of ions into a substrate for production of various regions containing impurities of the same type as the substrate impurity type;

Figure 5 is a cross-sectional view of the wafer of Figure 4 after completion of a step for ion implantation for production of various regions containing impurities of the same type as the substrate impurity type, excepting an area adjacent to the second region,

Figure 6 is a cross-sectional view of the wafer of Figure 4 after completion of a step for ion implantation for production of high impurity concentration portions of various regions containing impurities of the same type as the substrate impurity type,

Figure 7 is a cross-sectional view of the wafer of Figure 4 after completion of a step for production of a field insulating layer,

Figure 8 is a cross-sectional view of the wafer of Figure 4 after completion of the step for production of second and third regions,

Figure 9 is a cross-sectional view of a portion of a wafer containing a protection element in accordance with another embodiment of the present invention, and

Figure 10 is a cross-sectional view of a portion of a wafer containing a protection element in accordance with a further embodiment of the present invention.

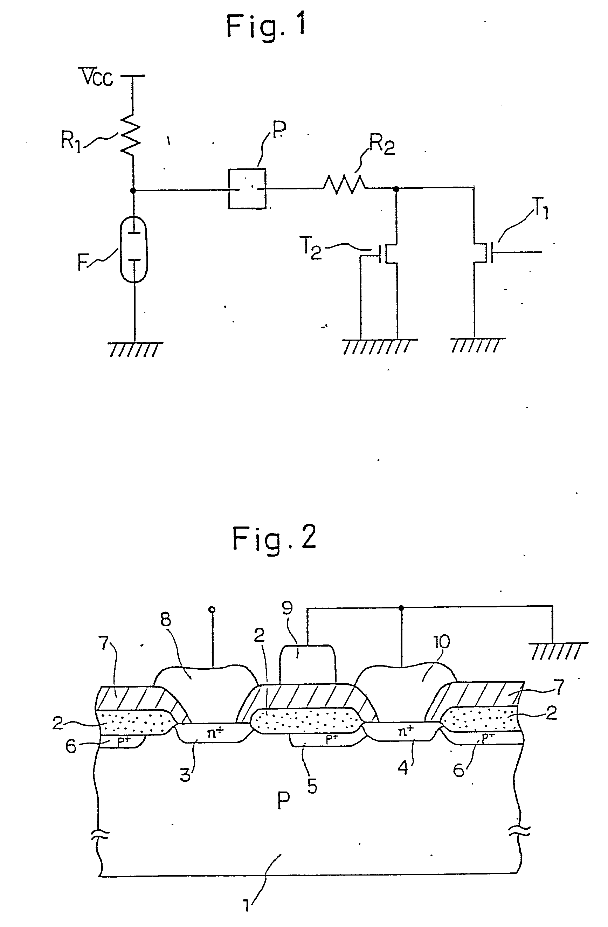

In Figure 1, $T_1$ is a transistor operative at a voltage of, for example, 40V, and this transistor $T_1$ is protected by a protection element $T_2$, which protection element is in accordance with an embodiment of the present invention, from having applied thereto an unduly high voltage, of for example 45V, which might otherwise be applied inadvertently from a power supply $V_{cc}$ which is a power supply for a fluorescent tube type display element F operative at a voltage of for example 40V. $R_1$ and $R_2$ are resistors and P is an input/output pad connecting elements contained in an integrated circuit and discrete elements, for example the fluorescent tube type display element F and the discrete resistor $R_1$. The input/output pad P is connected to one or more input terminals (not shown) of one or more input circuits (not shown) each of which is comprised of one or more ordinary transistors operative at a voltage of for example 5V, such one or more ordinary transistors being included in the integrated circuit device in question.

Referring to Figure 2, a first region 1 is a p type silicon (Si) substrate of which the top surface is mostly covered by a silicon dioxide ($SiO_2$) insulating layer 2. Two $n^+$ type regions (a second region 3 and a third region 4) are arranged in selected top portions of the silicon substrate 1, which selected portions are not covered by the $SiO_2$ insulating layer 2. These two regions function as the emitter and the collector of a lateral bipolar transistor which constitutes a protection element in accordance with one embodiment of the present invention. The two regions 3 and 4 are separated by a portion of the first region 1 which portion is covered by the $SiO_2$ insulating layer 2. In the first region 1, a fourth region, a $p^+$ type region 5, is arranged along the under-surface of the $SiO_2$ insulating layer 2. It is to be noted that the fourth region 5 does not completely bridge the interval or gap between the second region 3 and the third region 4. In other words, albeit that fourth region 5 contacts the third region 4, the fourth region 5 is separated from the second region 3. The substrate 1 functions as the base of the lateral bipolar transistor which constitutes a protection element in accordance with one embodiment of the present invention. Since a space is left between the second region 3 and the fourth region 5, the breakdown voltage of the second region 3 against the substrate 1 is increased to a level determined by the specific resistance of the substrate 1. The fourth region 5 functions to prevent a punch-through phenomenon occurring in the region between the second region 3 and the third region 4. However, if the fourth region 5 were to contact the second region, thereby bridging the second region 3 and the third region 4, the working voltage of the protection element would turn out to be determined in dependence upon the breakdown voltage between the fourth region 5 and the second region 3. This would mean that an unexpectedly low working voltage would be provided for the protection element, giving undesirable performance characteristics. This is the reason by the fourth region 5 should be separated from the second region 3. Needless to emphasise, $p^+$ type regions 6 arranged beneath the $SiO_2$ insulating layer 2 functioning as a field insulating layer are channel stoppers. 7 is a phosphosilicate glass (PSG) film covering the $SiO_2$ insulating layer 2 and having windows therein over the second region 3 and the third region 4. 8, 9 and 10 are respectively a first electrode 8 which connects the second region 3 to a protected element (not shown), an additional electrode 9 which is grounded and a second electrode 10 which grounds the third region 4. In the structure of Figure 2 the additional electrode 9 is not positively involved in providing the protection activity of the protection element embodying the present invention. The main reason for the production of the additional electrode 9 is to enable the protection element embodying the present invention to be produced by employment of the same processes as are used for production of other active or passive elements which, in combination with the protection element, are produced in an integrated circuit device. As described above, the additional electrode 9 is arranged on the phosphosilicate glass (PSG) 7. As a result, the protection element is protected from external contamination, caused by sodium ions ($Na^+$) or the like.

Accordingly, a type of lateral bipolar transistor having a structure as described with reference to Figure 2 can function as an element responsible for the protection of an associated ordinary element contained in an integrated circuit and the protection element can be provided with a working voltage higher than· that of protection elements previously available.

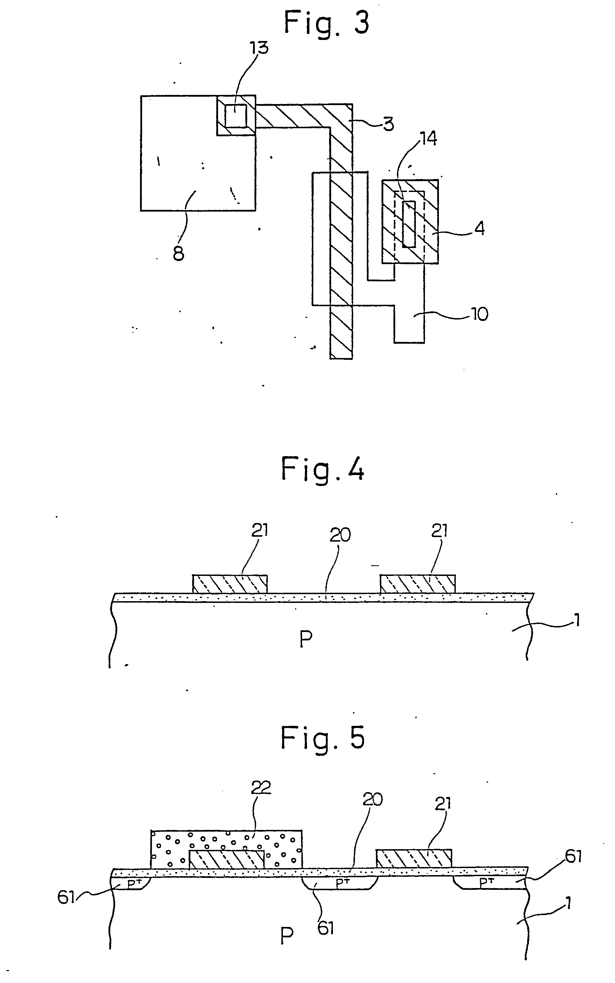

In Figure 3, 13 and 14 are respectively an area in which the second region 3 and the first electrode 8 are connected and an area in which the third region 4 and the second electrode 10 are connected.

Figures 4 to 8 illustrate steps in the production of a protection element embodying the present invention in a silicon wafer.

Figure 4 shows a silicon nitride ($Si_3N_4$) film 21, having a thickness of approximately 1000 angstroms, produced on selected areas of a silicon dioxide ($SiO_2$) film 20, having a thickness of a few hundred angstroms, for example 500 angstroms, or several times such a thickness, produced on the top surface of a p-type silicon (Si) substrate 1 having a specific resistance of 20 ohm-centimeters. The silicon nitride film 21 covers the silicon dioxide film 20 except in areas corresponding to fourth regions 5 and channel stoppers 6 (see Figure 2), and is employed as a mask for implantation of ions into the regions 5 and 6.

Figure 5 shows a photoresist film 22 produced to cover an area corresponding to the second region 3 and an area adjacent thereto, before boron (B) ions are implanted, employing an implantation energy of 60 KeV and a dose of $1 \times 10^{13}/cm^2$ for production of $p^+$ type regions 61, namely the fourth region 5 and the channel stoppers 6 as shown in Figure 2.

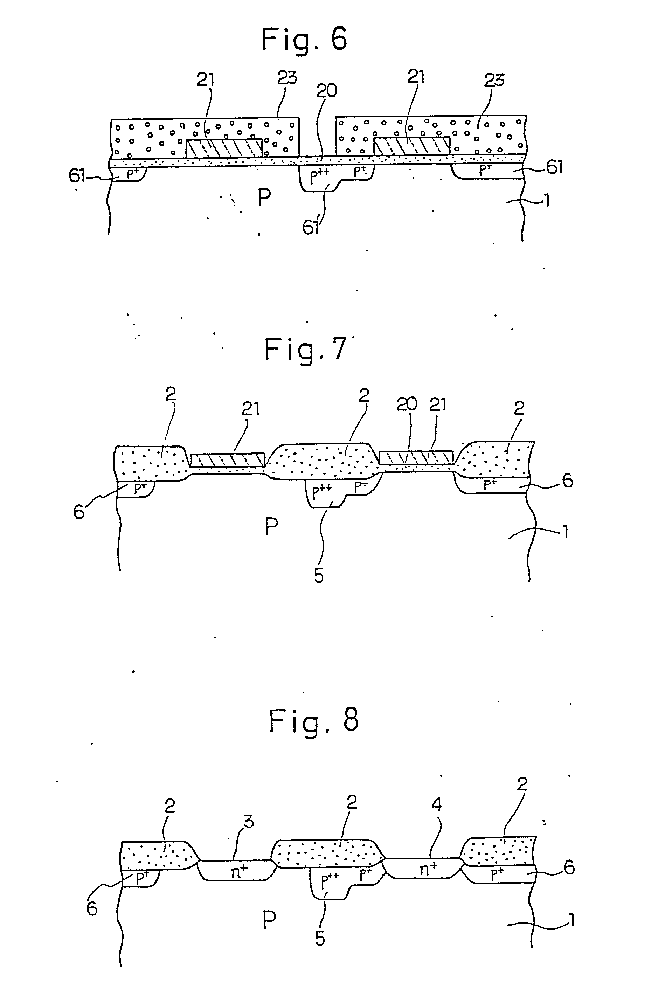

Referring to Figure 6, a photoprocess is employed for production of another photoresist film 23 covering the top surface of the substrate 1 except in areas corresponding to regions into which boron (B) ions are to be introduced to a higher concentration, before an ion implantation process is effected employing an implantation energy of 60 KeV and a dose of $4 \times 10^{13}/cm^2$ for production of $p^{++}$ type regions 61'. The reason why these $p^{++}$ type regions 61' are preferred is to cause high tension (high voltage) elements which are inevitably contained in an integrated circuit in question, to refrain from exhibiting the so-called parasitic transistor function.

Referring to Figure 7, the photoresist film 23 is removed, before a selective oxidation process employing wet oxygen is applied to the wafer for production of the silicon dioxide ($SiO_2$) insulating film having a thickness in the range 6,000 to 8,000 angstroms. The ultimate thickness and the impurity concentration of the $p^{++}$ type regions 61' are respectively 0.75 micrometers and $10^{17}/cm^3$. The corresponding figures for $p^+$ type regions 61 are respectively 0.6 micrometers and $10^{16}/cm^3$. Figure 7 illustrates that no impurities are introduced into the areas surrounding the second region 3 shown in Figure 2 and that the fourth region 5 and the channel stoppers 6 are produced.

Referring to Figure 8, arsenic (As) ions are implanted for the production of the $n^+$ type second region 3 and the $n^+$ type third region 4. The ion implantation energy employed is 120 KeV and the ion implantation is carried out until the dose reaches $4 \times 10^{15}/cm^2$. Needless to emphasise, other $n^+$ type regions are simultaneously produced for the other ordinary elements contained the same integrated circuit. The ultimate thickness and impurity concentration, realised by annealing, of the $n^+$ regions 3 and 4 are respectively 0.4 micrometers and $10^{20}/cm^3$. The following steps are quite similar to those for production of MOS field effect transistors. The $p^{++}$ type region 61' is not a necessarily essential part of a protection element in accordance with the present invention. However, in a case in which the impurity concentration of the p type silicon substrate 1 is marginal and a tendency is observed for leakage current readily to flow therein, the $p^{++}$

type region 61' is effective to decrease the amount of such leakage current.

Since reduction in geometrical dimensions is one of the most fundamental requirements of integrated circuits, the length of the fourth region is desired to be as short as possible. Albeit that the length of the fourth region is primarily limited by accuracy of positioning of masks etc., experimental results indicate that this dimension can be as small as 7 micrometers, leaving an interval or gap of 3 micrometers between the ends of the $n^+$ type second region and the $p^+$ type fourth region. A protection element having such dimensions has been determined to have a working voltage of 50V and is thus employable for protection of an ordinary element operative at a voltage of for example 40V or slightly higher.

It is to be emphasized that the present invention is particularly suitable for application to n channel elements, since it has been difficult previously to produce a n channel element which is fit to deal with high tension (high voltage).

The present invention is not limited to embodiments as described above in which the first region is p-type semiconductor substrate. Many other embodiments or modifications are available in accordance with the present invention. For example, a protection element embodying the present invention can be produced in a p-type well region selectively produced in a n type semiconductor substrate which is connected to a reference voltage, for example ground voltage. This type of protection element, having a p-type well region, functions predominantly as a vertical bipolar transistor in which the second region is the emitter, the first region or the p-type well region is the base and the semiconductor substrate is the collector, when the protection element is expected to deal with a relatively small electric current. On the other hand, the said protection element functions predominantly as a lateral bipolar transistor as described above when the protection element is expected to deal with a relatively large electric current.

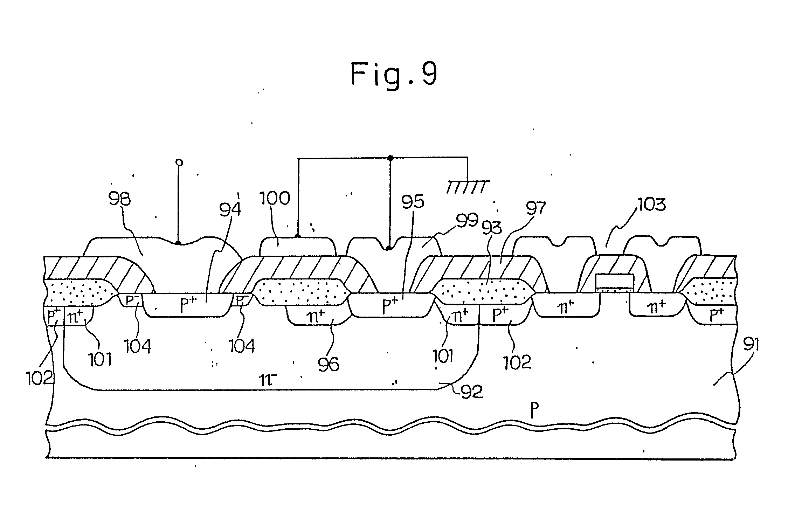

Figure 9 illustrates a protection element in accordance with another embodiment of the present invention. In Figure 9, 91 is a p type silicon (Si) substrate having a specific resistance of 20 ohm-centimeters, and 92 is a $n^-$ type well region, having an impurity concentration of $10^{16}/cm^3$ and a specific resistance of 0.5 to 1.0 ohm-centimeters, which is selectively produced to a depth of 5 micrometers in the silicon substrate 91. 93 is an insulating layer of silicon dioxide ($SiO_2$) selectively produced on top of the silicon substrate 91 and the well region 92. 94 and 95 are $p^+$ type regions having each a thickness and an impurity concentration of 0.6 micrometers and $10^{20}/cm^3$ and which are separated by the insulating layer 93. 96 is a $n^+$ type region having a thickness and an impurity concentration of 0.6 micrometers and $10^{17}/cm^3$ and which is produced along the bottom of the insulating layer 93 so as to contact the $p^+$ type region 95 but to be separated from the $p^+$ region 94. 97 is a phosphosilicate glass (PSG) layer produced on top of the insulating layer 93. 98 is a first electrode which connects the $p^+$ type region 94 and an ordinary element (not shown) to be protected by the protection element. 99 is a second electrode which grounds the $p^+$ type region 95. 100 is an additional electrode produced on top of the phosphosilicate glass (PSG) layer 97. 101 and 102 are respectively a $n^+$ type channel stopper having a thickness and an impurity concentration of 0.6 micrometers and $10^{17}/cm^3$ and a $p^+$ type channel stopper having a thickness and an impurity concentration of 0.6 micrometers and $10^{17}/cm^3$. 103 is a n channel type MOS field effect transistor element produced in the p type silicon substrate 91.

The $n^-$ type well region 92 performs a function corresponding to that of the first region described above in connection with Figure 2. Further, the $p^+$ type region 95 and the $n^+$ type region 96 respectively act as elements corresponding to the third region and the fourth region of a protection element in accordance with the present invention.

The impurity concentration of the $n^-$ type well region 92, in which the protection element is produced, is selected to be higher than that of the p type semiconductor substrate 91. Therefore, the specific resistance of the $n^-$ type well region 92 is less than that of the p type semiconductor substrate 91. Specifically, the specific resistance of the $n^-$ type well region 92 is selected to be 0.5 to 1.0 ohm-centimeters, as described above. Therefore, the extension of depletion layers from the $p^+$ type regions 94 and 95, both of which are produced in the $n^-$ type well region 92, into the $n^-$ type well region 92 becomes rather small, causing a relatively lesser magnitude of breakdown voltage between the $p^+$ type regions 94 and 95 and the $n^-$ type well region 92.

To remove this drawback, a protection element in accordance with this embodiment of the present invention is provided with a $p^-$ type region 104 having a thickness and an impurity concentration of 0.3 micrometers and $10^{16}/cm^3$ which is produced on top of the $n^-$ type well region 92 to surround the $p^+$ type region 94 which is the second region of the protection element embodying the present invention. A space is left between the $p^-$ type region 104 and the $n^+$ type region 96 which is the fourth region of a protection element embodying the present invention.

The arrangement of the $p^-$ type region 104 surrounding the $p^+$ type region 94 is effective to increase the extension of the depletion layers from the p type region consisting of the $p^+$ type region 94 and the $p^-$ region 104, into the $n^-$ type well region 92. Further, this is effected to decrease intensity of electric field around a circular zone in which the $p^+$ type region 94 and the top portion of the $n^-$ type well region 92 contact each other.

As a result, a considerable increase is realized for the breakdown voltage between the p type regions 94 and 104 and the well region 92, resultantly increasing the working voltage of the protection element provided with the $p^-$ type region 104. A proper selection of the conductivity, the impurity concentration and the depth of the $p^-$ type region 104 enables production of a protection element having a working voltage of approximately 40V.

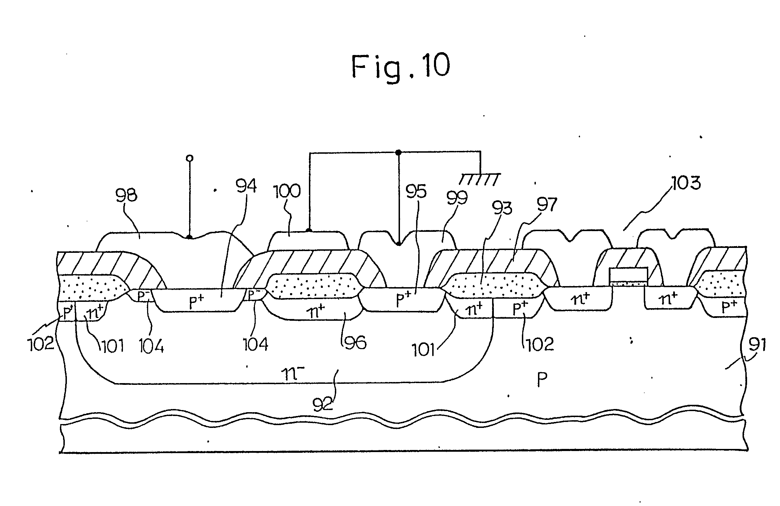

The embodiment of the present invention described with reference to Figure 9 can be modified to produce a further embodiment of the present invention as illustrated in Figure 10 for a case in which a slightly lesser working voltage, of approximately 30V, is required.

Referring to Figure 10, in which similar items are designated by the same reference numerals as are used in Figure 9, the $n^+$ type region 96 is arranged to contact the $p^-$ type region 104 in order to decrease the working voltage of the protection element. Because the breakdown voltage of the p-n junction appearing between the $p^-$ type region 104 and the $n^+$ type region 96 determines the working voltage of the protection element, a decrease in the working voltage is successfully achieved. Since the configuration of Figure 10 does not require space separating the $n^+$ type region 96 from the $p^-$ type region 104, a higher integration density can be realized for an integrated circuit device which includes one or more protection elements in accordance with the embodiment of Figure 10. The exclusion of the space separating the $n^+$ type region 96 from the $p^-$ type region 104 is effective to decrease the base width of the lateral bipolar transistor, resultantly increasing the current amplification factor ($h_{FE}$), and as a result further increasing the capacity for current absorption of this lateral bipolar transistor.

As indicated above, a protection element in accordance with an embodiment of the present invention can be considered to be a type of lateral bipolar transistor. Therefore, the function of a protection element in accordance with an embodiment of the present invention can be discussed in accordance with the principles governing lateral bipolar transistors.

An embodiment of the present invention provides an element responsible for the protection of an ordinary element, included in a semiconductor device, from the application thereto of a voltage higher than a voltage which is permitted to be applied. The protection element is in effect a virtual lateral bipolar transistor, which offers an increase in voltage at which the protection element operates.

## Claims

1. A protection element (T2), for protecting an ordinary element of a semiconductor device from the application thereto of a voltage higher than a maximum permissible voltage, the protection element (T2) comprising:

a first region (1, 92), of a first conductivity type, having an insulating layer (2, 93) covering a major part thereof;

a second region (3, 94), of a second conductivity type, opposite to the first conductivity type, provided in a first selected upper portion of the first region (1, 92);

a third region (4, 95), of the second conductivity type, provided in a second selected upper portion of the first region (1, 92);

a fourth region (5, 96), of the first conductivity type, of higher impurity concentration than the first region (1, 92), covered by the insulating layer (2, 93), between the second (3, 94) and third (4, 95) regions, contacting the third region (4, 95) but separated from the second region (3, 94); and

first (8, 98) and second (10, 99) electrodes connected respectively to the second region (3, 94) and the third region (4, 95).

2. A protection element as claimed in claim 1, wherein the first region is a semiconductor substrate (1).

3. A protection element as claimed in claim 1, wherein the first region is a well region (92) provided in a selected portion of a semiconductor substrate (91) of the second conductivity type.

4. A protection element as claimed in claim 1, 2 or 3, wherein the fourth region (5, 96) is separated from the second region (3, 94) by a portion of the first region (1, 92).

5. A protection element as claimed in claim 1, 2 or 3, wherein the fourth region (5, 96) is separated from the second region (3, 94) by a fifth region (104), of the second conductivity type, having a lesser impurity concentration than the second region (3, 94), formed in the first region (1, 92).

6. A protection element as claimed in claim 5, wherein the fourth region (5, 96) is separated from the second region (3, 94) by the said fifth region (104) and by a portion of the first region (1, 92).

7. A protection element as claimed in any preceding claim, wherein the fourth region (5) has a part ($p^{++}$), nearer to the second region (3) than the remainder ($p^+$) of the fourth region (5), provided with an impurity concentration higher than that of the remainder ($p^+$) of the fourth region (5).

8. A protection element as claimed in any preceding claim, further comprising an additional electrode (9, 100) formed above the insulating layer (2, 93) above the fourth region (5, 96).

## Patentansprüche

1. Schutzelement (T2), zum Schutz eines gewöhnlichen Elements einer Halbleitervorrichtung vor der Zuführung einer Spannung die höher als die maximal zulässige Spannung ist, welches Schutzelement (T2) umfaßt:

einen ersten Bereich (1, 92), von einem ersten Leitfähigkeitstyp, der eine isolierenden Schicht (2, 93) hat, die einen größeren Teil von ihm bedeckt;

einen zweiten Bereich (3, 94), von einem zweiten Leitfähigkeitstyp, der zum ersten Leitfähigkeitstyp entgegengesetzt ist, in einem ersten ausgewählten oberen Abschnitt des ersten Bereichs (1, 92);

einen dritten Bereich (4, 95), von dem zweiten Leitfähigkeitstyp, der in einem zweiten ausgewählten oberen Abschnitt des ersten Bereichs (1, 92) vorgesehen ist;

einen vierten Bereich (5, 96), von dem ersten Leitfähigkeitstyp, mit höherer Verunreinigungskonzentration als der erste Bereich (1, 92), der durch die isolierende Schicht (2, 93) bedeckt ist, zwischen dem zweiten (3, 94) und dritten (4, 95) Bereich, welcher den dritten Bereich (4, 95) kontaktiert jedoch von dem zweiten Bereich (3, 94) getrennt ist, und

erste (8, 98) und zweite (10, 99) Elektroden, die mit dem zweiten Bereich (3, 94) bzw. mit dem dritten Bereich (4, 95) verbunden sind.

2. Schutzelement nach Anspruch 1, bei welchem der erste Bereich ein Halbleitersubstrat (1) ist.

3. Schutzelement nach Anspruch 1, bei welchem der erste Bereich ein Grabenbereich (92) ist, der in einem ausgewählten Abschnitt des Halbleitersubstrats (91) von dem zweiten Leitfähigkeitstyp vorgesehen ist.

4. Schutzelement nach Anspruch 1, 2 oder 3, bei welchem der vierte Bereich (5, 96) von dem zweiten Bereich (3, 94) durch einen Abschnitt des ersten Bereichs (1, 92) getrennt ist.

5. Schutzelement nach Anspruch 1, 2 oder 3, bei welchem der vierte Bereich (5, 96) von dem zweiten Bereich (3, 94) durch einen fünften Bereich (104), vom zweiten Leitfähigkeitstyp, mit einer geringeren Verunreinigungskonzentration als der zweite Bereich (3, 94) getrennt ist, der in dem ersten Bereich (1, 92) gebildet ist.

6. Schutzelement nach Anspruch 5, bei welchem der vierte Bereich (5, 96) von dem zweiten Bereich (3, 94) durch den genannten fünften Bereich (104) und durch einen Abschnitt des ersten Bereichs (1, 92) gebildet ist.

7. Schutzelement nach einem der vorhergehenden Ansprüche, bei welchem der vierte Bereich (5) einen (p$^{++}$)-Abschnitt, näher an dem zweiten Bereich (3) als der Rest (p$^+$) des vierten Bereichs (5), hat, der eine Verunreinigungskonzentration aufweist, die höher als diejenige des Restes (p$^+$) des vierten Bereichs (5) ist.

8. Schutzelement nach einem der vorhergehenden Ansprüche, ferner mit einer zusätzlichen Elektrode (9, 100), die oberhalb der isolierenden Schicht (2, 93) oberhalb des vierten Bereichs (5, 96) gebildet ist.

**Revendications**

1. Elément de protection (T2) destiné à protéger un élément ordinaire d'un composant semi-conducteur contre l'application à cet élément d'une tension supérieure à une tension maximale permise, l'élément de protection (T2) comportant:

une première région (1, 92) d'un premier type de conductivité, dont une partie majeure est recouverte d'une couche isolante (2, 93); une seconde région (3, 94) d'un second type de conductivité opposé au premier type de conductivité, prévue dans une première partie supérieure déterminée de la première région (1, 92); une troisième région (4, 95) du second type de conductivité formée dans une seconde partie supérieure déterminée de la première région (1, 92), une quatrième région (5, 96) du premier type de conductivité, d'une plus forte concentration d'impuretés que la première région (1, 92) recouverte par la couche d'isolement (2, 93) entre la seconde (3, 94) et la troisième (4, 95) régions, en contact avec la troisième région (4, 95) mais séparée de la seconde région (3, 94) et une première (8, 98) et une seconde (10, 99) électrodes connectées respectivement à la seconde région (3, 94) et à la troisième région (4, 95).

2. Elément de protection selon la revendication 1, dans lequel la première région est un substrat semi-conducteur (1).

3. Elément de protection selon la revendication 1, dans lequel la première région est une région de puits (92) prévue dans une partie déterminée d'un substrat semi-conducteur (91) du second type de conductivité.

4. Elément de protection selon la revendication 1, 2 ou 3, dans lequel la quatrième région (5, 96) est séparée de la seconde région (3, 94) par une partie de la première région (1, 92).

5. Elément de protection selon la revendication 1, 2 où 3, dans lequel la quatrième région (5, 96) est séparée de la seconde région (3, 94) par une cinquième région (104) du second type de conductivité, ayant une concentration d'impuretés inférieure à celle de la seconde région (3, 94) formée dans la première région (1, 92).

6. Elément de protection selon la revendication 5, dans lequel la quatrième région (5, 96) est séparée de la seconde région (3, 94) par ladite cinquième région (104) et par une partie de la première région (1, 92).

7. Elément de protection selon l'une quelconque des revendications précédentes, dans lequel la quatrième région (5) comporte une partie (P$^{++}$) plus proche de la seconde région (3) que le reste (P$^+$) de la quatrième région (5) prévue avec une concentration d'impuretés supérieure à celle du reste (P$^+$) de la quatrième région (5).

8. Elément de protection selon l'une quelconque des revendications précédentes, comprenant en outre une électrode supplémentaire (9, 100) formée au-dessous de la couche d'isolement (2, 93) au-dessus de la quatrième région (5, 96).

# Fig. 1

# Fig. 2

## Fig. 3

## Fig. 4

## Fig. 5

2

## Fig. 6

## Fig. 7

## Fig. 8

# Fig.9

Fig.10